# EUROPÄISCHE PATENTSCHRIFT

(11) **EP 3 810 989 B1**
(45) Veröffentlichungstag und Bekanntmachung des Hinweises auf die Patenterteilung: **19.01.2022**
(21) Anmeldenummer: 19712976.0
(22) Anmeldetag: 20.03.2019
(51) Int. Cl.: F22B 33/18

(54) **VERFAHREN UND VORRICHTUNG ZUR BEREITSTELLUNG VON DAMPF**
PROCESS AND DEVICE FOR PROVIDING VAPOR
PROCÉDÉ ET DISPOSITIF DE PRÉPARATION DE VAPEUR

(30) Priorität: 20.06.2018 DE 102018004987
(43) Veröffentlichungstag der Anmeldung: 28.04.2021
(73) Patentinhaber: Singulus Technologies AG, 63796 Kahl am Main (DE)
(72) Erfinder: HOHN, Oliver, 63584 Gründau (DE); REISING, Michael, 63776 Mömbris (DE); GRÜBLER, Johannes, 01665 Käbschütztal (DE); PIETSCH, Kurt, 01099 Dresden (DE); KOCH, Jörg, 35232 Dautphetal (DE)
(74) Vertreter: Vossius & Partner Patentanwälte Rechtsanwälte mbB
(86) Internationale Anmeldenummer: PCT/EP2019/056998
(87) Internationale Veröffentlichungsnummer: WO 2019/242899

(56) Entgegenhaltungen:
- EP-A2- 2 256 406
- WO-A2-2011/080038
- DE-A1- 3 007 909
- DE-C- 414 324
- GB-A- 2 272 751
- US-A- 1 328 593

## Beschreibung

Die vorliegende Erfindung betrifft ein Verfahren sowie eine Vorrichtung zur Bereitstellung von Dampf für einen diskontinuierlichen Prozess sowie ein Verfahren zur Befüllung eines Prozessbereichs mit Dampf.

Für eine Vielzahl von industriellen Prozessen wird Dampf mit ganz bestimmten Eigenschaften unter wohldefinierten Bedingungen benötigt. So werden beispielsweise bei der Herstellung von Halbleitern oder Solarzellen sowie bei diversen Beschichtungsprozessen die benötigten Flüssigkeiten dem Prozess in der gasförmigen Phase als Dampf zugeführt. Für die Erzeugung des benötigten Dampfs aus den entsprechenden Flüssigkeiten (zum Beispiel metallorganischen Verbindungen oder Gemischen) sind verschiedene Verfahren bekannt, die unter anderem auf der Erhitzung der Flüssigkeit oder der sogenannten Direktverdampfung beruhen. Mit diesen Verfahren lässt sich im kontinuierlichen Betrieb, nach einer gewissen Einschwingphase, Dampf unter wohldefinierten, konstanten Bedingungen erzeugen. Allerdings ist der Bedarf an Dampf bei vielen industriellen Prozessen diskontinuierlich. So kann es sich bei dem Prozess selbst beispielsweise um einen getakteten Prozess handeln, der lediglich periodisch die Zuführung von Dampf verlangt. Darüber hinaus weist auch ein kontinuierlicher Prozess, der nicht permanent betrieben wird, Diskontinuitäten auf, nämlich beim Ein- bzw. Ausschalten des Prozesses. Herkömmlich wird dem dadurch begegnet, dass der Dampf kontinuierlich erzeugt wird und für den Fall, dass kein Dampf benötigt wird, über einen Bypass abgleitet wird, wie dies beispielsweise in der WO 2013/022669 A2 beschrieben ist. Dies führt jedoch zu einem unerwünschten Materialverlust. Ferner ist es aus der DE 10 2014 109 194 A1 bekannt, eine sogenannte "Modulationseinrichtung" vorzusehen, die in einer Dampflieferphase auf eine erste Modulationstemperatur temperiert wird, bei der der Dampf ohne Kondensation durch die Modulationseinrichtung hindurchtritt, und die in einer Unterbrechungsphase auf eine zweite Modulationstemperatur temperiert wird, bei der zumindest ein Teil des Dampfes kondensiert. Bei diesem Verfahren wird zwar der Materialverlust minimiert jedoch erfordert auch hier die Umstellung von der Unterbrechungsphase auf die Dampflieferphase einen Einschwingvorgang, da sich beim Aufheizen der Modulationseinrichtung und dem Verdampfen des kondensierten Dampfs nicht instantan ein konstanter Druck beziehungsweise ein konstanter Dampffluss erzeugen lässt.

Aus der GB 2 272 751 A ist ein Dampfspeicher mit einer Damp- und Wassersenke bekannt, der jedoch nicht dazu eingerichtet ist, Dampf für einen diskontinuierlichen oder geschalteten Prozess bereitzustellen.

Es ist daher eine Aufgabe der vorliegenden Erfindung, ein Verfahren sowie eine Vorrichtung zur Bereitstellung von Dampf für einen diskontinuierlichen oder geschalteten Prozess bereitzustellen, welche den eingangs diskutierten Problemen Rechnung tragen. Diese Aufgabe wird durch ein Verfahren beziehungsweise eine Vorrichtung gemäß den unabhängigen Ansprüchen gelöst. Die abhängigen Ansprüche richten sich auf besonders bevorzugte Merkmale.

Die vorliegende Erfindung betrifft unter anderem ein Verfahren zur Bereitstellung von Dampf für einen diskontinuierlichen oder geschalteten Prozess. Das Verfahren weist das Verdampfen einer Flüssigkeit in einem Direktverdampfer zur Erzeugung eines Dampfs sowie das Transportieren des Dampfs von dem Direktverdampfer über ein Speichervolumen zu einem Prozessbereich auf, wobei die Temperatur des Speichervolumens regelbar ist. Wenn im Prozessbereich kein Dampf benötigt wird, wird die Fluidverbindung zwischen dem Speichervolumen und dem Prozessbereich mittels eines automatisch geregelten Ventils unterbrochen, wobei während der Unterbrechung zumindest zeitweise weiterhin Dampf erzeugt und in das Speichervolumen transportiert wird, sodass der Druck innerhalb des Speichervolumens während der Unterbrechung ansteigt.

Mit anderen Worten basiert die vorliegende Erfindung unter anderem auf der Idee, bei einem diskontinuierlichen Bedarf von Dampf kontinuierlich Dampf zu erzeugen und diesen erzeugten Dampf in einem Speicher- beziehungsweise Puffervolumen zu speichern. Da der Druck innerhalb des Speichervolumens aufrechterhalten wird beziehungsweise bei weiterer Dampferzeugung auch während der Unterbrechung ansteigt, kann bei einem erneuten Bedarf an Dampf durch den Prozess instantan Dampf mit den benötigten, wohldefinierten Eigenschaften bereitgestellt werden. Da sich das Speichervolumen zwischen dem Direktverdampfer und dem Prozessbereich befindet, erfolgt während der Unterbrechung der Dampfzuführung keinerlei Materialverlust. Ferner lässt sich die Unterbrechung der Fluidverbindung sowie deren Wiederherstellung beim erfindungsgemäßen Verfahren sehr viel schneller und flexibler regulieren als dies beispielsweise für die Modulationseinrichtung der DE 10 2014 109 194 A1 möglich ist.

Das erfindungsgemäße Verfahren ist grundsätzlich für die Verdampfung beliebiger Flüssigkeiten anwendbar und insbesondere auch für die Verdampfung von metallorganischen Verbindungen oder Gemischen geeignet. Bevorzugt handelt es sich bei der zu verdampfenden Flüssigkeit um ein flüssiges Vorprodukt für die Photovoltaikindustrie und/oder die Halbleiterindustrie wie zum Beispiel Wasser und/oder metallorganische Verbindungen, insbesondere Trimethylaluminium (TMA1), Triethylaluminium (TEA1), Trimethylgallium (TMGa), Triethylgallium (TEGa), Dimethylzink (DMZn) und Diethylzink (DEZn). Dabei ist sowohl die Verdampfung von reinen Stoffen als auch von Stoffgemischen möglich. Typische Verdampfungsraten liegen im Bereich von einigen Milligramm pro Minute bis zu einigen Gramm pro Minute, sind jedoch nicht darauf beschränkt.

Der Transport des Dampfs von dem Direktverdampfer über das Speichervolumen zu dem Prozessbereich kann beispielsweise mittels eines Trägergases oder aufgrund eines Druckgefälles zwischen Direktverdampfer und Prozessbereich erfolgen.

Das Speicher-, Puffer- bzw. Vorratsvolumen kann eine separate Einheit darstellen, die über entsprechende Fluidverbindungen oder Leitungen mit dem Direktverdampfer einerseits und dem Prozessbereich andererseits verbunden ist. Das Speichervolumen kann jedoch auch durch eine entsprechend dimensionierte Leitung zwischen dem Direktverdampfer und dem Prozessbereich gebildet werden. Bevorzugt gilt dabei für das Speichervolumen Vspeicher, den temperaturabhängigen Dampfdruck pᵥₐₚ(T) der zu verdampfenden Flüssigkeit, die Temperatur T des Speichervolumens, den Massenfluss Q am Direktverdampfer und den Ausgangsdruck p₀ im Direktverdampfer vor der Unterbrechung der Fluidverbindung bei einer maximalen Dauer dt der Unterbrechung: V_{speicher}> (Q×dt) / (pᵥₐₚ (T) - p₀).

Es ist ferner bevorzugt, dass das Speichervolumen eine minimale Querschnittsfläche von mindestens 25 mm², bevorzugt mindestens 30 mm², stärker bevorzugt mindestens 35 mm² und besonders bevorzugt mindestens 40 mm² aufweist. Sind zwischen dem Direktverdampfer und Speichervolumen und/oder zwischen dem Speichervolumen und dem Prozessbereich Fluidleitungen vorgesehen, so haben auch diese Fluidleitungen bevorzugt dieselben minimalen Querschnittsflächen.

Bevorzugt ist der Druck im Speichervolumen, bevor die Verdampfung beginnt, kleiner als der Dampfdruck der zu verdampfenden Flüssigkeit, bevorzugt ist der Druck kleiner als 20 mbar besonders bevorzugt kleiner als 10 mbar.

Bevorzugt erfolgt die Unterbrechung der Fluidverbindung zwischen dem Speichervolumen und dem Prozessbereich lediglich für eine Dauer, während derer nicht mehr Flüssigkeit verdampft wird, als im Speichervolumen gespeichert werden kann. Bevorzugt wird die Fluidverbindung zwischen dem Speichervolumen und dem Prozessbereich für maximal 180 Sekunden, bevorzugt für maximal 150 Sekunden, stärker bevorzugt für maximal 120 Sekunden, noch stärker bevorzugt für maximal 90 Sekunden, noch stärker bevorzugt für maximal 60 Sekunden unterbrochen. Es ist besonders bevorzugt, dass die Unterbrechung kürzer als 30 Sekunden, bevorzugt kürzer als 20 Sekunden, stärker bevorzugt kürzer als 15 Sekunden, noch stärker bevorzugt kürzer als 10 Sekunden und besonders bevorzugt kürzer als 5 Sekunden erfolgt.

Bevorzugt erfolgt die Unterbrechung der Fluidverbindung zwischen dem Speichervolumen und dem Prozessberiech sowie deren Wiederherstellung automatisch. Hierfür kann beispielsweise ein entsprechender Regelungsmechanismus mit den hierfür notwendigen Informationen vom Prozessbereich versorgt werden. So kann beispielsweise der Prozessbereich jeweils ein Signal an den Regelmechanismus senden, wenn Dampf benötigt wird beziehungsweise wenn kein Dampf mehr benötigt wird.

Bevorzugt wird die Temperatur des Speichervolumens während der Unterbrechung geregelt. Besonders bevorzugt wird das Speichervolumen während der Unterbrechung beheizt. Die Regelung der Temperatur des Speichervolumens kann jedoch auch eine aktive Kühlung umfassen. Die Regelung der Temperatur erfolgt dabei bevorzugt derart, dass die Temperatur des Speichervolumens während der Unterbrechung mindestens so hoch ist, dass keine Kondensation des Dampfs innerhalb des Speichervolumens erfolgt. Hierdurch wird die Regelungsstabilität sowie die Reaktionszeit des erfindungsgemäßen Verfahrens verbessert. Die Temperatur des Speichervolumens sollte dabei unter der Zersetzungstemperatur der verdampften Flüssigkeit liegen. Für die Regelung der Temperatur ist das Speichervolumen bevorzugt mit einem oder mehreren Heizelementen versehen. Geeignete Heizelemente umfassen beispielsweise Heizbänder, Heizschläuche, Heizpatronen oder Heizmanschetten. Heizmanschetten bestehen aus Heizdraht, Isolation und Thermoelement. Alternativ können auch fluide Wärmeträger zum Einsatz kommen, um das Speichervolumen und andere Bauteile zu heizen. Alternativ oder zusätzlich kann das Speichervolumen auch mittels Strahlung beheizt werden. Dementsprechend kann das Heizelement auch einen Emitter für Strahlung, bevorzugt Infrarotstrahlung aufweisen.

Bevorzugt werden zur Regelung der Temperatur mehrere Heizkreise eingesetzt. Es ist ferner bevorzugt, dass die Temperatur des Speichervolumens auch zwischen den Unterbrechungen geregelt wird. Ist als Speichervolumen ein separates Element vorgesehen, das mit dem Direktverdampfer und/oder dem Prozessbereich über eine Leitung verbunden ist, so wird bevorzugt auch die Temperatur der Leitung zwischen dem Direktverdampfer und dem Speichervolumen und/oder der Leitung zwischen dem Speichervolumen und dem Prozessbereich während der Unterbrechung, besonders bevorzugt durchgehend, geregelt. Hierfür können weitere Heizelemente an den entsprechenden Leitungen vorgesehen sein. Erfindungsgemäß wird während der Unterbrechung der Fluidverbindung zwischen dem Speichervolumen und dem Prozessbereich zumindest zeitweise weiterhin Dampf erzeugt und in das Speichervolumen transportiert. Es ist bevorzugt, dass mindestens während 30%, bevorzugt mindestens während 50%, stärker bevorzugt während mindestens 70% und besonders bevorzugt während mindestens 90% der Unterbrechungsdauer weiterhin Dampf erzeugt und in das Speichervolumen transportiert wird. Die Dampferzeugung erfolgt während dieses Zeitraums bevorzugt kontinuierlich. Besonders bevorzugt wird während der gesamten Unterbrechung kontinuierlich, bevorzugt mit einer konstanten Rate, weiterhin Dampf erzeugt und in das Speichervolumen transportiert. Bevorzugt steigt der Druck innerhalb des Speichervolumens während der Unterbrechung um mindestens 5%, bevorzugt um mindestens 10%, stärker bevorzugt um mindestens 20%, noch stärker bevorzugt um mindestens 35% und besonders bevorzugt um mindestens 50% an.

Es ist bevorzugt, dass die Fluidverbindungen zwischen dem Speichervolumen und dem Prozessbereich wieder hergestellt wird, sobald im Prozessbereich Dampf benötigt wird. Bevorzugt erfolgt die Wiederherstellung der Fluidverbindungen automatisch und kann beispielsweise durch ein entsprechendes Signal vom Prozessbereich getriggert werden. Handelt es sich bei dem Prozess um einen getakteten Prozess, kann die Unterbrechung und Wiederherstellung der Fluidverbindung auch automatisch anhand eines vorbestimmten Zeitschemas erfolgen. Bevorzugt erfolgt die Unterbrechung und/oder Wiederherstellung der Fluidverbindung zwischen dem Speichervolumen und dem Prozessberiech mittels eines automatisch geregelten Ventils. Hierfür geeignete Ventile sind beispielsweise: Membranventile, ALD-Ventile oder Faltenbalkventile.

Bevorzugt handelt es sich bei dem diskontinuierlichen oder geschalteten Prozess um einen getakteten Prozess, sodass im Prozessbereich abwechselnd Dampf benötigt und kein Dampf benötig wird. In diesem Fall ist es bevorzugt, dass die Unterbrechung und Wiederherstellung der Fluidverbindungen zwischen dem Speichervolumen und dem Prozessbereich ebenfalls getaktet wird. Dabei wird bevorzugt während des gesamten Prozesses kontinuierlich, bevorzugt mit einer konstanten Rate, weiterhin Dampf erzeugt und in das Speichervolumen transportiert.

Wie bereits erwähnt, kann der Transport des Dampfs von dem Direktverdampfer über das Speichervolumen zu dem Prozessbereich über einen Druckgradienten erfolgen. Bevorzugt wird der Dampf mittels eines Trägergases von dem Direktverdampfer über das Speichervolumen zu dem Prozessbereich transportiert. In diesem Fall ist es bevorzugt, dass die Zufuhr von Trägergas unterbrochen wird, solange die Fluidverbindung zwischen dem Speichervolumen und dem Prozessbereich unterbrochen ist. Geeignete Trägergase sind beispielsweise: inerte Gase, die mit dem Dampf nicht reagieren, insbesondere N2, Ar, H2 oder Gasgemische aus diesen.

Wie bereits eingangs erwähnt, ist das erfindungsgemäße Verfahren zur Bereitstellung von Dampf für beliebige diskontinuierliche oder geschaltete Prozesse und insbesondere für getaktete Prozesse geeignet. Ein wichtiger Anwendungsbereich für das erfindungsgemäße Verfahren ist die (Erst-)Befüllung eines Prozessbereichs mit Dampf, da auch der Beginn eines ansonsten kontinuierlichen Prozesses eine Diskontinuität darstellt. Dementsprechend richtet sich die vorliegende Erfindung auch auf ein Verfahren zur Befüllung eines Prozessbereichs mit Dampf aus einem Direktverdampfer, welcher über ein Speichervolumen und eine Fluidverbindung mit dem Prozessbereich verbunden ist. Das Verfahren weist das Verdampfen einer Flüssigkeit in dem Direktverdampfer zur Erzeugung eines Dampfs auf, während die Fluidverbindung zwischen dem Speichervolumen und dem Prozessbereich unterbrochen ist. Das Verdampfen erfolgt so lange, bis eine vorbestimmte Befüllbedingung erfüllt ist. Dann wird die Fluidverbindung zwischen dem Speichervolumen und dem Prozessbereich mittels eines automatisch geregelten Ventils wiederhergestellt und der Prozessbereich mit Dampf befüllt.

Mit diesem Verfahren kann besonders schnell Dampf unter vorbestimmten Bedingungen in den Prozessbereich eingeleitet werden.

Bevorzugt umfasst die vorbestimmte Befüllbedingung eine oder eine Kombination der folgenden Bedingungen: Erreichen einer vorbestimmten, bevorzugt konstanten, Verdampfungsrate; Erreichen eines vorbestimmten Drucks und/oder Dampfvolumens in dem Speichervolumen.

Bevorzugt ist der Druck in dem Speichervolumen vor dem Beginn der Verdampfung kleiner als der Dampfdruck der Flüssigkeit.

Es ist ferner bevorzugt, dass das Speichervolumen während des Verdampfens beheizt wird.

Für den Fachmann ist ersichtlich, dass die oben im Hinblick auf das Verfahren zur Bereitstellung von Dampf für einen diskontinuierlichen Prozess beschriebenen bevorzugten Merkmale in analoger Weise auch auf das erfindungsgemäße Verfahren zur Befüllung eines Prozessbereichs mit Dampf aus einem Direktverdampfer angewandt werden können.

Es ist bevorzugt, dass der Prozessbereich Teil einer Beschichtungsanlage, bevorzugt einer Vakuumbeschichtungsanlage, ist. Bevorzugt ist der Prozessbereich Teil einer Beschichtungsanlage für CVD, PE-CVD, Epitaxie, MO-CVD und/oder MOVPE, mit der unter anderem dünne Schichten von unterschiedlichen Materialien (wie z.B. metallische, dielektrische, halbleitende und/oder organische Werkstoffe) erzeugt werden kann.

Die vorliegende Erfindung richtet sich ferner auf eine Vorrichtung zur Bereitstellung von Dampf für einen diskontinuierlichen oder geschalteten Prozess. Die Vorrichtung weist einen Direktverdampfer zur Erzeugung eines Dampfs, ein mit dem Direktverdampfer in Fluidverbindung stehendes Speichervolumen und eine Temperaturregelung auf, mittels derer die Temperatur des Speichervolumens geregelt werden kann. Ferner weist die Vorrichtung eine Leitung auf, mittels derer das Speichervolumen mit einem Prozessbereich verbunden werden kann. Die Leitung weist ein Ventil auf. Die Vorrichtung weist ferner eine Steuereinheit auf, die dazu geeignet und eingerichtet ist, den Direktverdampfer und das Ventil so zu steuern, dass das Ventil offen ist und der erzeugte Dampf von dem Direktverdampfer über das Speichervolumen zu dem Prozessbereich transportiert wird, wenn im Prozessbereich Dampf benötigt wird, dass das Ventil geschlossen wird, wenn im Prozessbereich kein Dampf benötigt wird, und dass während der Unterbrechung zumindest zeitweise weiterhin Dampf erzeugt wird, sodass der Druck innerhalb des Speichervolumens während der Unterbrechung ansteigt.

Die Steuereinheit ist bevorzugt dazu geeignet und eingerichtet, die Temperaturregelung so zu steuern, dass die Temperatur des Speichervolumens während der Unterbrechung geregelt wird. Bevorzugt ist die Steuereinheit ferner dazu geeignet und eingerichtet, die Temperaturregelung so zu steuern, dass die Temperatur des Speichervolumens während der Unterbrechung mindestens so hoch ist, dass keine Kondensation des Dampfs innerhalb des Speichervolumens erfolgt.

Bevorzugt wird während der gesamten Unterbrechung kontinuierlich, bevorzugt mit einer konstanten Rate, weiterhin Dampf erzeugt und in das Speichervolumen transportiert.

Bevorzugt weist die Vorrichtung ferner eine Leitung zur Zuführung von Trägergas auf, welche mittels eines weiteren Ventils unterbrochen werden kann. Bevorzugt ist die Steuereinheit ferner dazu geeignet und eingerichtet, das weitere Ventil zu schließen, solange die Fluidverbindung zwischen dem Speichervolumen und dem Prozessbereich unterbrochen ist. Bevorzugt variiert der Fluss des Trägergases im Bereich von 0 bis 5 slm.

Bevorzugt weist das Speichervolumen und/oder die Leitung, mittels derer das Speichervolumen mit einem Prozessbereich verbunden werden kann, eine Innenquerschnittsfläche von mindestens 25 mm², bevorzugt von mindestens 30 mm², stärker bevorzugt von mindestens 35 mm² und besonders bevorzugt von mindestens 40 mm² auf.

Bevorzugt ist die Vorrichtung dazu geeignet, das oben beschriebene Verfahren mit dessen bevorzugten Merkmalen durchzuführen.

Die vorliegende Erfindung richtet sich ferner auf eine Beschichtungsanlage, bevorzugt eine Vakuumbeschichtungsanlage, zur Beschichtung eines Substrats. Die Beschichtungsanlage weist einen Prozessbereich sowie eine Vorrichtung wie oben beschrieben auf, deren Leitung mit dem Prozessbereich verbunden ist. Bevorzugt handelt es sich um eine Beschichtungsanlage für CVD, PE-CVD, Epitaxie, MO-CVD und/oder MOVPE, mit der unter anderem dünne Schichten von unterschiedlichen Materialien (wie z.B. metallische, dielektrische, halbleitende und/oder organische Werkstoffe) erzeugt werden kann.

Der Prozessbereich weist bevorzugt eine Prozesskammer mit einem Kammervolumen V_{K} auf. Für den Partialdruck pₚ der zu verdampfenden Flüssigkeit in der Prozesskammer, das Speichervolumen V_{S} und den maximalen Druck im Speichervolumen pₘₐₓ gilt bevorzugt, dass das Verhältnis (V_{K} ^{∗} pₚ)/(V_{S} ^{∗} pₘₐₓ) < 20, bevorzugt < 10, stärker bevorzugt < 5, noch stärker bevorzugt < 2 und besonders bevorzugt < 0,75 ist.

Die erfindungsgemäßen Verfahren sowie die erfindungsgemäßen Vorrichtungen sind aus verschiedenen Gründen vorteilhaft gegenüber dem Stand der Technik. Gegenüber herkömmlichen Lösungen mit Bypass entsteht bei der erfindungsgemäßen Lösung kein Materialverlust. Ferner kann die Verdampfung sehr stabil betrieben werden und es tritt beim abrupten Einschalten keine Einregelphase auf. Beim abrupten Einlassen des gespeicherten Gases vom Speichervolumen in den Prozessbereich wird durch die zusätzliche Gasmenge aus dem Speichervolumen die Zeit bis zum Einstellen stabiler Druckverhältnisse im Gesamtsystem verkürzt. Der Prozess kann somit früher gestartet werden, da keine Wartezeit bis zum Einstellen einer stabilen, konstanten Verdampfungsrate erforderlich ist. Bevorzugte Ausführungsformen der erfindungsgemäßen Lösung ermöglichen einen oder mehrere der folgenden Vorteile: Bereitstellung von Dampf für diskontinuierliche Prozesse; schnelles Ein- bzw. Ausschalten der Dampfzufuhr in den Prozessbereich; schnelles Befüllen des Prozessraums trotz kontinuierlicher Verdampfung; verbesserte Ausnutzung der Flüssigkeit; kein Materialverlust; verkürzte Dauer, bis ein stabiler Zustand im Prozess erreicht wird; verkürzte Dauer zur Einstellung einer stabilen Gaszusammensetzung bzw. eines stabilen Drucks im Prozessraum; Verkürzung der Wartezeit bis zum Prozessstart; höherer Durchsatz bei getakteter Abscheidung; maximale Nutzungsdauer nicht durch die Verdampfung begrenzt, da Flüssigkeit kontinuierlich aus einem Vorrat bei niedriger Temperatur nachgeliefert werden kann; Verdampfungsrate ist nicht sensitiv auf Temperatur und Druck; Skalierung für beliebige Verdampfungsraten möglich; Anpassung an Prozessraum und Gasverteilungssystem möglich; Betrieb mit/ohne Trägergas möglich; Vorrichtung bzw. Verfahren kann für Flüssigkeiten und Gemische mit unterschiedlichen thermischen Eigenschaften genutzt werden.

Nachfolgend wird eine bevorzugte Ausführungsform der vorliegenden Erfindung anhand der Figuren beschrieben. Es zeigen:

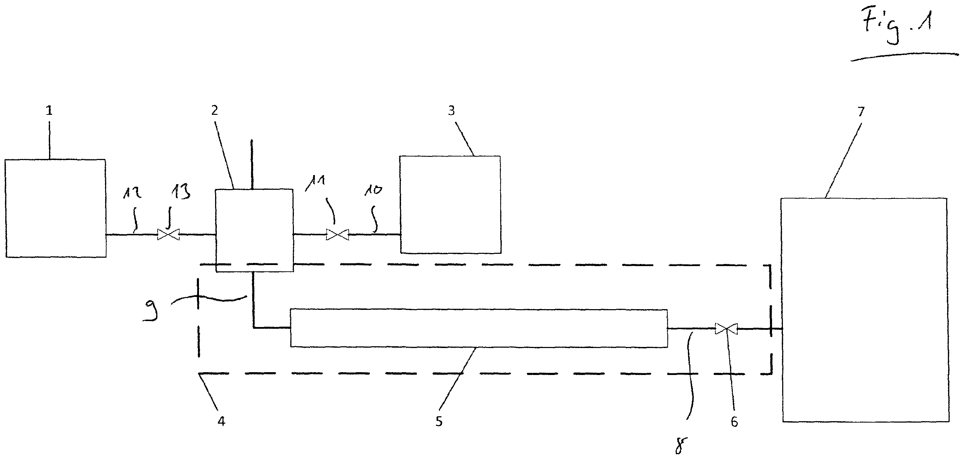

- Figur 1:: Eine Vorrichtung zur Bereitstellung von Dampf für einen diskontinuierlichen Prozess gemäß einer bevorzugten Ausführungsform.

Figur 1 zeigt schematisch eine Vorrichtung zur Bereitstellung von Dampf für einen diskontinuierlichen Prozess gemäß einer bevorzugten Ausführungsform. Der diskontinuierliche Prozess erfolgt in dem ebenfalls dargestellten Prozessbereich 7, der nicht Teil der erfindungsgemäßen Vorrichtung ist. Die Vorrichtung weist einen Direktverdampfer 2 zur Erzeugung eines Dampfs aus Flüssigkeit auf, die aus einer Flüssigkeitsdosierung 1 über die Leitung 12 dem Direktverdampfer 2 zur Verfügung gestellt wird. Die Leitung 12 lässt sich mittels des Ventils 13 schließen und öffnen. Ferner weist die Vorrichtung ein mit dem Direktverdampfer 2 über eine Leitung 9 in Fluidverbindung stehendes Speichervolumen 5 auf. Die Temperatur des Speichervolumens 5 lässt sich mittels der Temperaturregelung 4 regeln. Die Vorrichtung weist ferner eine Leitung 8 auf, mittels derer das Speichervolumen 5 mit dem Prozessbereich 7 verbunden werden kann, wobei in der Leitung 8 ein Ventil 6 vorgesehen ist. Ferner weist die Vorrichtung eine nicht dargestellte Steuereinheit auf, die dazu geeignet und eingerichtet ist, den Direktverdampfer 2 und das Ventil 6 so zu steuern, dass das Ventil 6 offen ist und der erzeugte Dampf von dem Direktverdampfer 2 über das Speichervolumen 5 zu dem Prozessbereich 7 transportiert wird, wenn im Prozessbereich 7 Dampf benötigt wird, dass das Ventil 6 geschlossen wird, wenn im Prozessbereich 7 kein Dampf benötigt wird, und dass während der Unterbrechung zumindest zeitweise weiterhin Dampf erzeugt wird, sodass der Druck innerhalb des Speichervolumens 5 während der Unterbrechung ansteigt.

In der in Figur 1 dargestellten Ausführungsform ist die Temperaturregelung 4, die bevorzugt ein oder mehrere Heizelemente aufweist, derart ausgelegt, dass nicht nur die Temperatur des Speichervolumens 5, sondern auch die Temperatur der Leitung 9 zwischen dem Direktverdampfer 2 und dem Speichervolumen 5 und der Leitung 8 zwischen dem Speichervolumen 5 und dem Prozessbereich 7 geregelt werden kann. Damit kann sichergestellt werden, dass im gesamten Bereich zwischen dem Direktverdampfer 2 und dem Prozessbereich 7 kein Dampf kondensiert.

In der dargestellten bevorzugten Ausführungsform erfolgt der Transport des Dampfs vom Direktverdampfer 2 über das Speichervolumen 5 zum Prozessbereich 7 über ein Trägergas. Hierfür weist die Vorrichtung eine Leitung 10 zur Zuführung von Trägergas auf, welche mittels eines weiteren Ventils 11 unterbrochen werden kann. Der Volumenstrom des Trägergases wird bevorzugt durch den Durchflussregler 3 geregelt.

Bevorzugt ist die nicht dargestellte Steuereinheit auch dazu geeignet und eingerichtet, das weitere Ventil 11 zu schließen, solange die Fluidverbindung 8 zwischen dem Speichervolumen 5 und dem Prozessbereich 7 unterbrochen ist. Es ist ferner bevorzugt, dass die Steuereinheit auch die Flüssigkeitsdosierung 1 und/oder das Ventil 13 in der Leitung 12 und/oder den Durchflussregler 3 steuert.

Die Flüssigkeitsdosierung 1 kann beispielsweise mit einem Massendurchflussregler für Flüssigkeit erfolgen, der thermische, Coriolis- und/oder Ultraschall-Messverfahren einsetzt. Alternativ kann eine Kombination aus einem Massendurchflussmessgerät mit einem Regelventil oder einem Dosiersystem mit Dosierpumpe (z.B. Mikrozahnpumpe, Kolbenpumpe, Membranpumpe) eingesetzt werden. Im Direktverdampfer erfolgt die vollständige Verdampfung der zugeführten Flüssigkeit durch Energiezufuhr und Temperaturregelung. Das Regelventil der Flüssigkeitsdosierung 1 kann auch im Direktverdampfer 2 oder in der Leitung 12 (bspw. in Form des Ventils 13 oder als zusätzliches Regelventil) integriert sein. Ferner können die in Figur 1 als getrennte Einheiten dargestellte Flüssigkeitsdosierung 1 und der Direktverdampfer 2 auch eine gemeinsame Einheit bilden.

Die Erfindung ist jedoch nicht auf die in der Figur 1 gezeigte oder die oben beschriebenen Anordnungen beschränkt. Vielmehr können auch andere dem Fachmann bekannte Verfahren zur Dosierung und direkten Verdampfung eingesetzt werden.

## Patentansprüche

1. Verfahren zur Bereitstellung von Dampf für einen diskontinuierlichen Prozess, welches aufweist:
Verdampfen einer Flüssigkeit in einem Direktverdampfer (2) zur Erzeugung eines Dampfs;
Transportieren des Dampfs von dem Direktverdampfer (2) über ein Speichervolumen (5) zu einem Prozessbereich (7), wobei die Temperatur des Speichervolumens (5) regelbar ist;
wobei die Fluidverbindung zwischen dem Speichervolumen (5) und dem Prozessbereich (7) mittels eines automatisch geregelten Ventils (6) unterbrochen wird, wenn im Prozessbereich (7) kein Dampf benötigt wird, und wobei während der Unterbrechung zumindest zeitweise weiterhin Dampf erzeugt und in das Speichervolumen (5) transportiert wird, so dass der Druck innerhalb des Speichervolumens (5) während der Unterbrechung ansteigt.

2. Verfahren nach Anspruch 1, wobei die Temperatur des Speichervolumens (5) während der Unterbrechung geregelt wird, wobei bevorzugt das Speichervolumen (5) während der Unterbrechung beheizt wird, wobei die Temperatur des Speichervolumens (5) während der Unterbrechung bevorzugt mindestens so hoch ist, dass keine Kondensation des Dampfs innerhalb des Speichervolumens (5) erfolgt.

3. Verfahren nach einem der vorhergehenden Ansprüche, wobei während der Unterbrechung kontinuierlich, bevorzugt mit einer konstanten Rate, weiterhin Dampf erzeugt und in das Speichervolumen (5) transportiert wird.

4. Verfahren nach einem der vorhergehenden Ansprüche, wobei der diskontinuierliche Prozess ein getakteter Prozess ist, so dass im Prozessbereich (7) abwechselnd Dampf benötigt und kein Dampf benötigt wird, wobei die Unterbrechung und Wiederherstellung der Fluidverbindung zwischen dem Speichervolumen (5) und dem Prozessbereich (7) ebenfalls getaktet wird und wobei während des gesamten Prozesses kontinuierlich, bevorzugt mit einer konstanten Rate, weiterhin Dampf erzeugt und in das Speichervolumen (5) transportiert wird.

5. Verfahren nach einem der vorhergehenden Ansprüche, wobei der Dampf mittels eines Trägergases von dem Direktverdampfer (2) über das Speichervolumen (5) zu dem Prozessbereich (7) transportiert wird, wobei die Zufuhr von Trägergas unterbrochen wird, solange die Fluidverbindung zwischen dem Speichervolumen (5) und dem Prozessbereich (7) unterbrochen ist.

6. Verfahren zur Befüllung eines Prozessbereichs mit Dampf aus einem Direktverdampfer, welcher über ein Speichervolumen und eine Fluidverbindung mit dem Prozessbereich verbunden ist, wobei das Verfahren aufweist:
Verdampfen einer Flüssigkeit in dem Direktverdampfer zur Erzeugung eines Dampfs, während die Fluidverbindung zwischen Speichervolumen und Prozessbereich unterbrochen ist, bis eine vorbestimmte Befüllbedingung erfüllt ist;
Wiederherstellen der Fluidverbindung zwischen Speichervolumen und Prozessbereich mittels eines automatisch geregelten Ventils (6); und
Befüllen des Prozessbereichs mit Dampf.

7. Verfahren nach Anspruch 6, wobei die vorbestimmte Befüllbedingung eine oder eine Kombination der folgenden Bedingungen umfasst: Erreichen einer vorbestimmten, bevorzugt konstanten, Verdampfungsrate; Erreichen eines vorbestimmten Drucks und/oder Dampfvolumens in dem Speichervolumen.

8. Verfahren nach Anspruch 6 oder 7, wobei der Druck in dem Speichervolumen vor dem Beginn der Verdampfung kleiner ist als der Dampfdruck der Flüssigkeit.

9. Verfahren nach einem der Ansprüche 6-8, wobei das Speichervolumen während des Verdampfens beheizt wird.

10. Vorrichtung zur Bereitstellung von Dampf für einen diskontinuierlichen Prozess, welche aufweist:
einen Direktverdampfer (2) zur Erzeugung eines Dampfs;
ein mit dem Direktverdampfer (2) in Fluidverbindung stehendes Speichervolumen (5);
eine Temperaturregelung (4), mittels derer die Temperatur des Speichervolumens (5) geregelt werden kann;
eine Leitung (8), mittels derer das Speichervolumen (5) mit einem Prozessbereich (7) verbunden ist wobei die Leitung (8) ein Ventil (6) aufweist;
und eine Steuereinheit, die dazu geeignet und eingerichtet ist, den Direktverdampfer (2) und das Ventil (6) so zu steuern, dass:
das Ventil (6) offen ist und der erzeugte Dampf von dem Direktverdampfer (2) über das Speichervolumen (5) zu dem Prozessbereich (7) transportiert wird, wenn im Prozessbereich (7) Dampf benötigt wird,
das Ventil (6) geschlossen wird, wenn im Prozessbereich (7) kein Dampf benötigt wird, und während der Unterbrechung der Fluidverbindung zwischen dem Speichervolumen und dem Prozessbereich zumindest zeitweise weiterhin Dampf erzeugt wird, so dass der Druck innerhalb des Speichervolumens (5) während der Unterbrechung ansteigt.

11. Vorrichtung nach Anspruch 10, wobei die Steuereinheit ferner dazu geeignet und eingerichtet ist, die Temperaturregelung (4) so zu steuern, dass die Temperatur des Speichervolumens (5) während der Unterbrechung geregelt wird.

12. Vorrichtung nach einem der Ansprüche 10 - 11, wobei die Steuereinheit ferner dazu geeignet und eingerichtet ist, die Temperaturregelung (4) so zu steuern, dass die Temperatur des Speichervolumens (5) während der Unterbrechung mindestens so hoch ist, dass keine Kondensation des Dampfs innerhalb des Speichervolumens (5) erfolgt.

13. Vorrichtung nach einem der Ansprüche 10 - 12, wobei während der Unterbrechung kontinuierlich, bevorzugt mit einer konstanten Rate, weiterhin Dampf erzeugt und in das Speichervolumen (5) transportiert wird.

14. Vorrichtung nach einem der Ansprüche 10 - 13, ferner mit einer Leitung (10) zur Zuführung von Trägergas, welche mittels eines weiteren Ventils (11) unterbrochen werden kann, wobei die Steuereinheit ferner dazu geeignet und eingerichtet ist, das weitere Ventil (11) zu schließen, solange die Fluidverbindung zwischen dem Speichervolumen (5) und dem Prozessbereich (7) unterbrochen ist.

15. Vorrichtung nach einem der Ansprüche 10 - 14, wobei das Speichervolumen (5) und/oder die Leitung (8), mittels derer das Speichervolumen (5) mit einem Prozessbereich (7) verbunden werden kann, eine Innenquerschnittsfläche von mindestens 25 mm², bevorzugt von mindestens 40 mm² aufweist.

## Claims

1. A method for providing vapor for a discontinuous process, the method comprising:
evaporating a liquid in a direct evaporator (2) for generating vapor;
transporting the vapor from the direct evaporator (2) to a process region (7) via a storage volume (5), wherein the temperature of the storage device (5) is controllable;
wherein the fluid connection between the storage volume (5) and the process region (7) is interrupted by an automatically controlled valve (6) if no vapor is required in the process region (7), and wherein vapor continues to be generated and transported into the storage volume (5) at least temporarily during the interruption so that the pressure within the storage volume (5) increases during the interruption.

2. The method according to claim 1, wherein the temperature of the storage volume (5) is controlled during the interruption, wherein preferably the storage volume (5) is heated during the interruption, wherein during the interruption the temperature of the storage volume (5) is at least high enough that no condensation of the vapor occurs within the storage volume (5).

3. The method according to any one of the preceding claims, wherein vapor continues to be generated and transported into the storage volume (5) continuously during the interruption, preferably at a constant rate.

4. The method according to any one of the preceding claims, wherein the discontinuous process is a clocked process so that vapor is alternatingly required or not required within the process region (7), wherein the interruption and restoration of the fluid connection between the storage volume (5) and the process region (7) is clocked as well and wherein vapor continues to be generated and transported into the storage volume (5) continuously during the complete process, preferably at a constant rate.

5. The method according to any one of the preceding claims, wherein the vapor is transported from the direct evaporator (2) to the process region (7) via the storage volume (5) by means of a carrier gas, wherein the supply of carrier gas is interrupted as long as the fluid connection between the storage volume (5) and the process region (7) is interrupted.

6. A method for filling a process region with vapor from a direct evaporator that is connected with the process region via a storage volume and a fluid connection, wherein the method comprises:
evaporating a liquid in the direct evaporator for generating vapor while the fluid connection between the storage volume and the process region is interrupted until a predetermined filling condition is met;
restoring the fluid connection between the storage volume and the process region by means of an automatically controlled valve (6); and
filling the process region with vapor.

7. The method according to claim 6, wherein the predetermined filling condition comprises one or a combination of the following conditions: reaching a predetermined, preferably constant evaporation rate; reaching a predetermined pressure and/or vapor volume in the storage volume.

8. The method according to claim 6 or 7, wherein the pressure in the storage volume is smaller than the vapor pressure of the liquid before evaporation begins.

9. The method according to any one of claims 6 to 8, wherein the storage volume is heated during evaporation.

10. An apparatus for providing vapor for a discontinuous process, the apparatus comprising:
a direct evaporator (2) for generating vapor;
a storage volume (5) in fluid connection with the direct evaporator (2);
a temperature control (4) by means of which the temperature of the storage (5) may be controlled;
a conduit (8) by means of which the storage volume (5) is connected with a process region (7), wherein the conduit (8) comprises a valve (6);
and a control unit which is suitable and configured for controlling the direct evaporator (2) and the valve (6) such that:
the valve (6) is open and the generated vapor is transported from the direct evaporator (2) to the process region (7) via the storage volume (5) if vapor is required in the process region,
the valve (6) is closed if no vapor is required in the process region (7), and
vapor continues to be generated at least temporarily during the interruption of the fluid connection between the storage volume and the process region so that the pressure within the storage volume (5) increases during the interruption.

11. The apparatus according to claim 10, wherein the control unit is further suitable and configured for controlling the temperature control (4) such that the temperature of the storage volume (5) is controlled during the interruption.

12. The apparatus according to any one of claims 10 to 11, wherein the control unit is further suitable and configured for controlling the temperature control (4) such that the temperature of the storage volume (5) is at least high enough during the interruption that no condensation of the vapor takes place within the storage volume (5).

13. The apparatus according to any one of claims 10 to 12, wherein vapor continues to be generated and transported into the storage volume (5) continuously during the interruption, preferably at a constant rate.

14. The apparatus according to any one of claims 10 to 13, further comprising a conduit (10) for supplying a carrier gas, the conduit (10) being interruptible by means of an additional valve (11), wherein the control unit is further suitable and configured for closing the additional valve (11) as long as the fluid connection between the storage volume (5) and the process region (7) is interrupted.

15. The apparatus according to any one of claims 10 to 14, wherein the storage volume (5) and/orthe conduit (8) by means of which the storage volume (5) may be connected with a process region (7) comprises an inner cross-sectional area of at least 25 mm², preferably of at least 40 mm².

## Revendications

1. Procédé pour la préparation de vapeur pour un processus discontinu, qui présente:
l'évaporation d'un liquide dans un évaporateur direct (2) pour la production d'une vapeur;
le transport de la vapeur de l'évaporateur direct (2) par le biais d'un volume de stockage (5) vers une zone de processus (7), où la température du volume de stockage (5) peut être régulée;
où la liaison fluidique entre le volume de stockage (5) et la zone de processus (7) est interrompue au moyen d'une vanne régulée automatiquement (6) quand aucune vapeur n'est nécessaire dans la zone de processus (7), et où pendant l'interruption de la vapeur continue à être produite et à être transportée dans le volume de stockage (5) au moins temporairement, de sorte que la pression à l'intérieur du volume de stockage (5) augmente pendant l'interruption.

2. Procédé selon la revendication 1, où la température du volume de stockage (5) est régulée pendant l'interruption, où de préférence le volume de stockage (5) est chauffé pendant l'interruption, où la température du volume de stockage (5) pendant l'interruption est de préférence au moins si élevée qu'aucune condensation de la vapeur ne se produit à l'intérieur du volume de stockage (5).

3. Procédé selon l'une des revendications précédentes, où pendant l'interruption, de la vapeur continue à être produite et à être transportée dans le volume de stockage (5) en continu, de préférence à un débit constant.

4. Procédé selon l'une des revendications précédentes, où le processus discontinu est un processus cadencé, de sorte que tour à tour de la vapeur est nécessaire et qu'aucune vapeur n'est nécessaire dans la zone de processus (7), où l'interruption et le rétablissement de la liaison fluidique entre le volume de stockage (5) et la zone de processus (7) sont également cadencés et où pendant tout le processus, de la vapeur continue à être produite et à être transportée dans le volume de stockage (5) en continu, de préférence à un débit constant.

5. Procédé selon l'une des revendications précédentes, où la vapeur est transportée au moyen d'un gaz vecteur de l'évaporateur direct (2) par le biais du volume de stockage (5) vers la zone de processus (7), où l'apport de gaz vecteur est interrompu tant que la liaison fluidique entre le volume de stockage (5) et la zone de processus (7) est interrompue.

6. Procédé pour le remplissage d'une zone de processus avec de la vapeur provenant d'un évaporateur direct, qui est relié à la zone de processus par le biais d'un volume de stockage et d'une liaison fluidique, où le procédé présente:
l'évaporation d'un liquide dans l'évaporateur direct pour la production d'une vapeur, tandis que la liaison fluidique entre le volume de stockage et la zone de processus est interrompue, jusqu'à ce qu'une condition de remplissage prédéterminée soit remplie;
le rétablissement de la liaison fluidique entre le volume de stockage et la zone de processus au moyen d'une vanne régulée automatiquement (6); et
le remplissage de la zone de processus avec de la vapeur.

7. Procédé selon la revendication 6, où la condition de remplissage prédéterminée comprend une ou une combinaison des conditions suivantes: obtention d'un débit d'évaporation prédéterminé, de préférence constant; obtention d'une pression et/ou d'un volume de vapeur prédéterminé dans le volume de stockage.

8. Procédé selon la revendication 6 ou 7, où la pression dans le volume de stockage avant le début de l'évaporation est inférieure à la pression de vapeur du liquide.

9. Procédé selon l'une des revendications 6 à 8, où le volume de stockage est chauffé pendant l'évaporation.

10. Appareil pour la préparation de vapeur pour un processus discontinu, qui présente:
un évaporateur direct (2) pour la production d'une vapeur;
un volume de stockage (5) en liaison fluidique avec l'évaporateur direct (2);
une régulation de température (4) au moyen de laquelle la température du volume de stockage (5) peut être régulée;
une conduite (8), au moyen de laquelle le volume de stockage (5) est relié à une zone de processus (7), où la conduite (8) présente une vanne (6);
et une unité de commande qui est adaptée et agencée pour commander l'évaporateur direct (2) et la vanne (6) de telle manière que:
la vanne (6) est ouverte et la vapeur produite est transportée de l'évaporateur direct (2) vers la zone de processus (7) par le biais du volume de stockage (5) lorsque de la vapeur est nécessaire dans la zone de processus (7),
la vanne (6) est fermée lorsqu'aucune vapeur n'est nécessaire dans la zone de processus (7), et
pendant l'interruption de la liaison fluidique entre le volume de stockage et la zone de processus, de la vapeur continue à être produite au moins temporairement, de sorte que la pression à l'intérieur du volume de stockage (5) augmente pendant l'interruption.

11. Dispositif selon la revendication 10, où l'unité de commande est en outre adaptée et agencée pour commander la régulation de température (4) de telle sorte que la température du volume de stockage (5) est régulée pendant l'interruption.

12. Dispositif selon l'une des revendications 10 à 11, où l'unité de commande est en outre adaptée et agencée pour commander la régulation de température (4) de telle sorte que, pendant l'interruption, la température du volume de stockage (5) est au moins si élevée qu'aucune condensation de la vapeur ne se produit à l'intérieur du volume de stockage (5).

13. Dispositif selon l'une des revendications 10 à 12, où pendant l'interruption, de la vapeur continue à être produite et à être transportée dans le volume de stockage (5) en continu, de préférence à un débit constant.

14. Dispositif selon l'une des revendications 10 à 13, avec en outre une conduite (10) pour l'apport de gaz vecteur, qui peut être interrompu au moyen d'une autre vanne (11), où l'unité de commande est en outre adaptée et agencée pour fermer l'autre vanne (11) tant que la liaison fluidique entre le volume de stockage (5) et la zone de processus (7) est interrompue.

15. Dispositif selon l'une des revendications 10 à 14, où le volume de stockage (5) et/ou la conduite (8) au moyen de laquelle le volume de stockage (5) peut être relié à une zone de processus (7), présente une aire de la section transversale intérieure d'au moins 25 mm², de préférence d'au moins 40 mm².
